# EUROPEAN PATENT SPECIFICATION

(11) **EP 2 333 950 B1**
(45) Date of publication and mention of the grant of the patent: **29.06.2016**
(21) Application number: 10193086.5
(22) Date of filing: 30.11.2010
(51) Int. Cl.: H03F 3/193, H03F 3/217

(54) **Digital power amplifier with I/Q combination**
Digitaler Leistungsverstärker mit I/Q-Kombination
Amplificateur de puissance numérique avec combinaison I/Q

(30) Priority: 30.11.2009 NL 2003880
(43) Date of publication of application: 15.06.2011
(73) Proprietor: Technische Universiteit Delft, 2628 CN Delft (NL)
(72) Inventor: Staszewski, Bogdan, 2625 KJ Delft (NL); de Vreede, Leonardus Cornelis Nicolaas, 2641 VX Pijnacker (NL)
(74) Representative: Nederlandsch Octrooibureau

(56) References cited:
- WO-A1-2008/076021
- US-A1- 2006 291 589

## Description

### Field of the invention

The present invention relates to an electronic circuit, such as a digital power amplifier as part of a transmitter, for receiving a modulating signal comprising an in-phase component (I) and a quadrature component (Q), the electronic circuit comprising a first digital-to-RF-amplitude convertor (DRAC) receiving the in-phase component and a second digital-to-RF-amplitude convertor (DRAC) receiving the quadrature component.

### Prior art

### A. Analog-Intensive RF transmitters

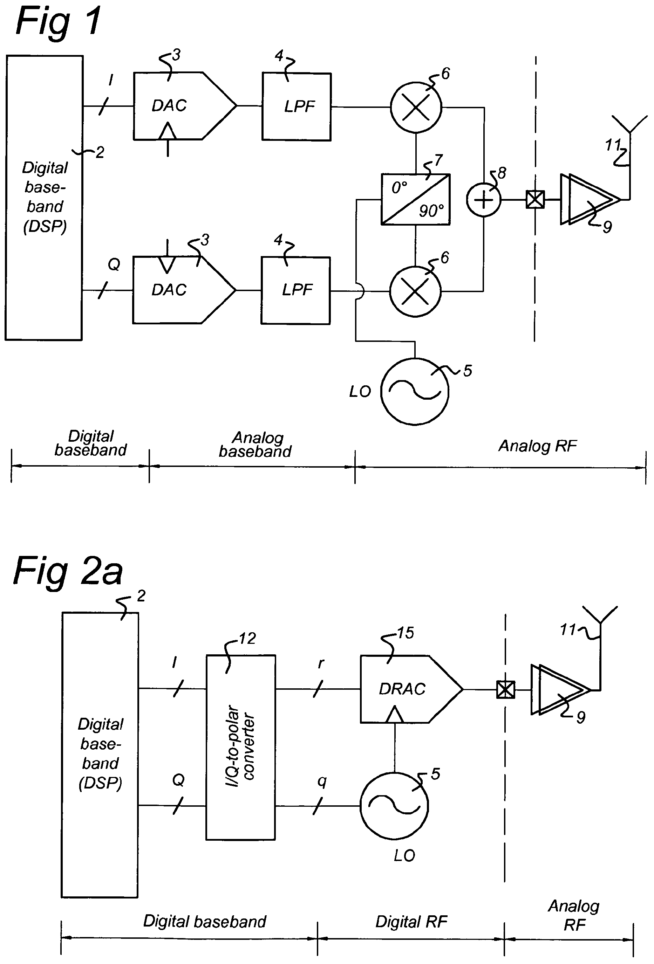

Until around mid-1990's, virtually all monolithic radio frequency (RF) transmitters (TX) have been analog intensive and based on an architecture similar to that shown in the block diagram of Fig. 1. At the transmitter back-end, the baseband user information symbols get pulse-shaped to obtain two orthogonal components of complex-number digital samples, i.e., in-phase (I) and quadrature (Q), that are constrained to the allocated frequency channel, using digital baseband block 2 (e.g. a DSP). They are then converted into analog continuous time domain through a set of digital-to-analog converters 3 (DAC) with a typical zero-order-hold (ZOH) function. The low-pass filter 4 (LPF) following the DAC 3 then filters out the switching harmonics. Thus obtained analog baseband signal gets then up converted (frequency translated) into RF through an image reject single-sideband (SSB) modulator. The SSB modulator typically comprises two multipliers or mixers 6, and uses a local oscillator 5 signal, which is 90° shifted for the I- and Q-phase using a phase shifter 7, and an adder 8 adding the two up converted signals. A following (typically external) power amplifier 9 (PA) increases the RF power level at an antenna 11 to that required by the wireless standard, which could be as high as 2 W for a GSM handset. The frequency synthesizer-based local oscillator 5 (LO) performs the frequency translation. It is typically realized as a charge-pump PLL with ∑Δ dithering of the divider modulus to realize the fractional-*N* frequency division ratio.

The complete architecture and monolithic circuit design techniques of the conventional transmitter of Fig. 1 have been well described in numerous literature and text books, see in particular references [1] and [2]. These architectures have been successfully used in integrated CMOS transmitters [3] for over a decade (since late 1990's). Unfortunately, its useful lifetime is slowly coming to an end in favor of analog polar and more digitally-intensive architectures as described in the following.

Alternative to the I/Q topology of the Fig. 1 transmitter is a polar realization, in which the two orthogonal components are amplitude *A* = |*S*| and phase Φ = *angle(S),* or *S = Ae^{jΦ},* where *S* is a complex-envelope signal. The phase modulation could be performed by a direct or indirect frequency modulation of a phase-locked loop (PLL). The amplitude modulation could be performed by a low dropout (LDO) voltage regulator modulating the *V_{dd}* supply of a high-efficiency switched-mode PA, such as class-E PA. The analog polar TX architecture is a more recent development to address the inherent power efficiency and noise issues of the I/Q architecture.

In the past several years, such analog-intensive polar transmitters (both small-signal, i.e. at the transceiver IC level, and large signal, i.e. encompassing PA) have been touted for their reconfigurability, implementational and performance benefits over their traditional Cartesian counterparts that are based on an I/Q upconversion mixer. A number of recent publications have demonstrated their superiority through highly-integrated silicon realizations [5]-[11], but only for the *narrowband* (200 kHz allocated bandwidth) modulation standard, EDGE, of the Second Generation or 2G cellular. The polar architecture migration to *wideband* modulation standards, such as Third Generation or 3G (WCDMA- allocated bandwidth of 5 MHz), Fourth Generation or 4G (3GPP LTE, WiMAX - allocated bandwidth of up to 20 MHz) and other evolving wideband wireless standards (e.g., 802.11n) remains a daunting task and, so far, there has been no silicon demonstrations in the open literature. The effort, however, appears to continue with so far one theoretical proposal of the polar topology for WCDMA [12] and one 90-nm CMOS demonstration of the RF front-end block components of the WCDMA digital polar transmitter [13].

### B. Digitally-Intensive RF Transmitters

As mentioned above, the digital approach to designing RF circuits and architectures is taking over in industry. The main reasons behind this sea-like transformation are the ever improving cost advantages and processing capabilities of the CMOS technology, which have been happening at regular intervals with the pace according to the so-called Moore's Law. Basically, with every CMOS process technology advancement node (i.e., from 130-nm to 90-nm, then to 65-nm, and then to 40-nm, and so on) happening every 18-24 months, the digital gate density, being a measure of the digital processing capability, doubles (i.e., gate area scaling factor of 0.5x). At the same time, the basic gate delay, being a measure of the digital processing speed, improves linearly (i.e., gate delay scaling factor of 0.7x). Likewise, the cost of fabricated silicon per unit area remains roughly the same at its high-volume production maturity stage. Indeed, over the last decade, the cost of silicon charged by integrated circuit (IC) fabs has remained constant at around US$ 0.10-0.25/mm², depending on the wafer volume and targeted gross profit margin (GPM). The main implication of this is that a cost of a given digital function, such as a GSM detector or an MP3 decoder, can be cut in half every 18-24 months when transitioned to a newer CMOS technology. At the same time, the circuits consume proportionately less power and are faster.

Unfortunately, these wonderful benefits of the digital scaling are not shared by the traditional RF circuits. What's more, the strict application of earlier described architectures to the advanced CMOS process node might actually result in a larger silicon area, poorer RF performance and higher consumed power. The constant scaling of the CMOS technology has had an unfortunate effect on the linear capabilities of analog transistors. To maintain reliability of scaled-down MOS devices, the *Vdd* supply voltage keeps on going down, while the threshold voltage *Vt* remains roughly constant (to maintain the low level of leakage current). This has a negative effect on the available voltage margin when the transistors are intended to operate as current sources. What' s more, the implant pockets added for the benefit of digital operation, have drastically degraded the MOS channel dynamic resistance *r*_{ds}, thus severely reducing the quality of MOS current sources and the maximum available voltage self-gain *gₘ*· *r_{ds}* (*gₘ* is the transconductance gain of a transistor). Furthermore, due to the thin gate dielectric becoming ever thinner, large high-density capacitors realized as MOS switches are becoming unacceptably leaky. This prevents an efficient implementation of low-frequency baseband filters and charge-pump PLL loop filters.

### C. New Paradigm of RF Design in Nanometer-Scale CMOS

An early attempt at designing RF circuits in advanced CMOS revealed a new paradigm [14]:
In a deep-submicron CMOS process, time-domain resolution of a digital signal edge transition is superior to voltage resolution of analog signals.

On a pragmatic level, this means that a successful design approach in this environment would exploit this paradigm by emphasizing the following:
- fast switching characteristics or high *f_{T}* (20 ps and 250 GHz in 40-nm CMOS process, respectively) of MOS transistors: high-speed clocks and/or fine control of timing transitions;
- high density of digital logic (1 Mgates/mm²) and SRAM memory (4 Mb/mm²) makes digital functions and assistant software extremely inexpensive;
- ultra-low equivalent power-dissipation capacitance *C_{pd}* of digital gates leading to both low switching power consumption *(P_{T}=f· Cpd· V_{dd}² )* as well as potentially low coupling power into sensitive analog blocks;
- small device geometries and precise device matching made possible by the fine lithography in order to create high-quality analog data converters;
while avoiding the following:
- biasing currents that are commonly used in analog designs;
- reliance on voltage resolution with ever decreasing supply voltages and increasing noise and interferer levels;
- nonstandard devices that are not needed for memory and digital circuits, which constitute majority of the silicon die area.

Despite the early misconceptions that the digitalization of RF would somehow produce more phase noise, spurs and distortion, the resulting digitally-intensive architecture is likely to be overall more robust by actually producing lower phase noise and spurious degradation of the transmitter chain and lower noise figure of the receiver chain in face of millions of active logic gates on the same silicon die, as repeatedly proven in subsequent publications [15] - [18]. Additionally, the new architecture would be highly reconfigurable with analog blocks that are controlled by software to guarantee the best achievable performance and parametric yield. Another benefit of the new architecture would be an easy migration from one process node to the next without significant rework.

### D. All-Digital Polar Transmitter

The transmitter architecture that is amenable to the digital nanoscale CMOS technology is shown in the schematic diagram of Fig. 2a [15] [16]. It has been deployed in mass production since around mid-2000's. Similar to the embodiments described above, a digital baseband block 2 provides I- and Q-signals, now to an I/Q-to-polar converter 12, providing polar signals (*ρ*, *θ*). The LO 5 is realized as an all-digital PLL (ADPLL) that produces a phase/frequency-modulated digital clock carrier using the two-point digital modulation scheme. The clock is fed into a digital-to-RF-amplitude converter 15 (DRAC) that produces an RF output whose envelope is substantially proportional to the amplitude control word (ACW) or p. Hence, the architecture is termed a digital polar TX. Again, a power amplifier 9 could be used to provide the signal to the antenna 11.

The DRAC 15 can be realized as an all-digital RF power generation circuit [19]. Sometimes it is also referred to in the literature as a digitally-controlled power amplifier (DPA), although this would appear somewhat of a misnomer. The input signal is an internal digital clock, so measuring the *amplification* gain of the DPA seems a little problematic. The DRAC 15 has proven its use for the power ramp as well as amplitude modulation in more advanced modulation schemes, such as the extended data rate (EDR) mode of Bluetooth, EDGE and WCDMA.

The DRAC 15 operates as a near-class-E RF PA and is driven by the square wave output of the digitally-controlled oscillator (DCO) in the ADPLL. The rise-/fall-time of digital signals, including clocks, is typically 20-40 ps, which makes the trapezoidal shape quite close to a square one for cellular band signals. A large number of core NMOS transistors are used as on/off switches, each with a certain conductance 1/*R*, and are followed by a matching network that interfaces with an antenna 11 or an external PA 9. The number of active switches, and thus the total conductance ∑(1/*R*), is controlled digitally and establishes the instantaneous amplitude of the output RF envelope. The RF output power is created by coherently moving the resonating energy through an LC tank between the load and the switches. The supply V*_{dd}* replenishes the energy lost to the load and internally. The RF amplitude is based on the relationship between the total switch conductance and the conductance of the matching network.

The class-E PA operation is attempted to be satisfied at the maximum output power (all the switches are active), where the highest achievable efficiency matters the most. Note that there could be different types of conversions from digital to RF amplitude as well as classes of operation. For example, class-D PA would use two switching devices operating complementary and connected to the supply/ground and the matching network.

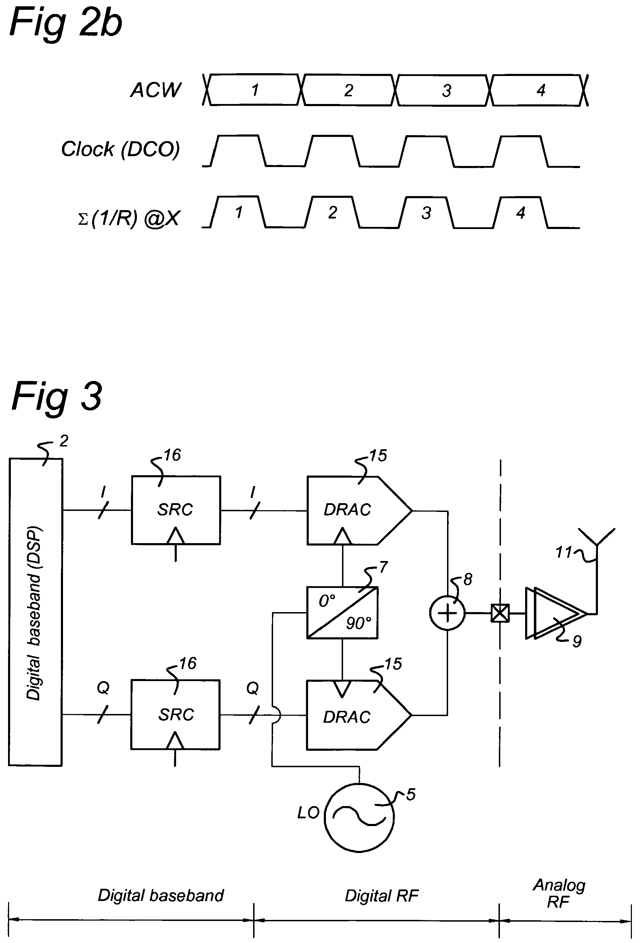

Fine amplitude resolution is achieved through high-speed ∑Δ transistor switch dithering. The timing diagram in Fig. 2b [19] assumes that the data changes every RF clock cycle, which is reasonable given the high-speed dithering. In practice, the integer ACW signals would change every certain number of DCO cycles. Despite the high speed of digital logic operation, the overall power consumption of the transmitter architecture is lower than that of architectures to date.

### E. All-Digital I/Q Transmitter

As mentioned above, due to the bandwidth expansion of *p* and *θ*, which could be as much as 10x of the original I/Q signal bandwidth, it might be difficult to apply the digital polar TX architecture to the wideband modulation, especially the most recent 3GPP LTE cellular and 802.1 In wireless connectivity standards. The required bandwidths would be on the order of hundreds of MHz. Consequently, the digital I/Q architecture was introduced [20] [21] to maintain the digital RF approach while addressing the bandwidth expansion problem of the polar topology.

A typical architecture is shown in Fig. 3. A new optional circuit, sample-rate converter 16 (SRC), is added to convert the lower-rate baseband I/Q signal (processed at integer multiple of the symbol rate) into a much higher rate necessary to spread the quantization noise, thus lowering its spectral density. Note that this optional SRC circuit 16 could also be used in the Fig. 2a digital polar TX as part of the I/Q-to-polar converter 12.

The operation of the digital I/Q modulator is as follows. The I and Q digital samples drive their respective DRAC converters 15 that produce two RF signal components, whose amplitude is ideally proportional to the respective I/Q digital input. The frequency and phase of the RF signal follows the respected clock input. As such, the phase of the DRAC Q output is 90° delayed with respect to that of the I output. The two amplitude-modulated RF components are then added together (using adder 8) to produce the desired composite RF output. The output is then transmitted to the antenna 11 directly or through a high-power PA 9.

This digital I/Q architecture does not appear to compare favorably with the polar topology of Fig. 2a. The digital I/Q architecture seems more complex with extra circuitry adding noise and creating signal distortion. The frequency modulation of the LO 5 could be satisfactorily accomplished through the well-known two-point modulation scheme of the ADPLL. The phase component is thus under the closed-loop feedback, which reduces the noise and distortion content falling within the ADPLL loop bandwidth. Closing the loop around the I/Q modulator RF output is typically much more difficult. The traditional issues of the timing misalignment in the analog polar architecture is not a problem anymore with the digital approach. The digital discrete-time operation is by construction clock-cycle accurate while the modern technology can easily support sampling rates even at the GHz range, as well as ultra-fast settling of the DPA conversion circuits (with the speed governed by *f_{T}*)*.* Consequently, the circuits of digital architectures can ensure fine time accuracy, which is constant and not subject to process and environmental changes.

The DRAC 15 could be implemented as a digitally-controlled RF-modulated current source [21]. This way, the addition of the two DRAC output components could be as simple as connecting them electrically. For the I/Q signal orthogonality to hold, these two current sources need to be ideal such that one signal path output does not affect the operation of the other. This means the need to resort to current source impedance boost techniques, such as cascoding. Unfortunately, stacking of the MOS transistors in a cascode structure is difficult in the modern low-voltage technologies and further produces leakage and excessive amount of noise. In addition, the quadrature phases are needed, which might complicate the LO clock 5 generation and distribution.

Such art is also found in US2006/0291589.

### Summary of the invention

The present invention seeks to provide a solution which fulfils a need for a digital TX architecture that is capable of supporting advanced wideband wireless modulation standards, but which avoids the intrinsic bandwidth expansion issues of the polar topology and the severe noise issues of the conventional digital I/Q architectures.

According to the present invention, an electronic circuit according to the preamble defined above is provided, wherein the first digital-to-RF-amplitude convertor is operative in a first duty cycle that is different from 50% and the second digital-to-RF-amplitude convertor is operative in a second duty cycle that is different from 50% and substantially the same in value as said first duty cycle. In an embodiment, the first duty cycle is 25% and the second duty cycle is 25%. In this manner an improved digital transmitter architecture is provided in the area of complexity, noise, distortion and linearity issues prior art systems.

In a further embodiment, the first DRAC receives an I-clock signal and the second DRAC receives a Q-clock signal, the duty cycle of the I-clock signal being equal to the first duty cycle and the duty cycle of the Q-clock signal being equal to the second duty cycle, the first duty cycle and second duty cycle being subsequent to each other in time, or in other words adjacent or neighboring. The first and second duty cycle may be partially overlapping, e.g. in the case of non-zero rise and fall time of the clock signals.

The in-phase component and the quadrature component comprise a respective amplitude control word, each of the first and second DRAC's comprising a controllable switch array having an array of AND gates, each AND gate receiving the respective clock signal and one of the bits of the respective ACW, the output of each AND gates being connected to an associated one of a plurality of MOS transistor switches, the outputs of each of the plurality of MOS transistors being connected to a summation node. Such a controllable switch array may be easily implemented in e.g. MOS techniques. In an embodiment, the switch arrays of the first and second DRAC's are implemented in the electronic circuit with an interleaved lay-out. This improves the ease of manufacturing, and also enhances the regularity of the DRAC's so formed.

In a further embodiment, each of the first and second DRAC comprises an output impedance connected in series between the output of each MOS transistor and the summation node. This allows to increase the resolution and dynamic range of the RF envelope control (when the impedance accuracy and range are better than those of the transistor switches).

In an even further embodiment, the first DRAC and the second DRAC form one (single) circuit. This also enhances the ease of developing and manufacturing the electronic circuit, e.g. in MOS technique.

The electronic circuit further comprising a matching network for driving an analog RF part in even further embodiments, the matching network being connected to a summation node of the first and second DAC, and comprising an LC resonant circuit which combines subsequent I and Q contributions in a single clock cycle. The LC resonant circuit provides a memory type of operation, allowing to add the subsequent I and Q contributions in each clock cycle. E.g. the matching network operates with a third duty cycle which is equal to the sum of the first duty cycle and the second duty cycle.

In further embodiments of the present invention, the matching network is adjustable. Even more, the matching network may be dynamically controlled. This adjustable matching network can be used to adjust for a new frequency channel, or to adjust the matching network impedance to a changing envelope level in order to maximize the power added efficiency (PAE).

In a further group of embodiments, the electronic circuit comprises a first pair of DRAC's receiving positive components of the I and Q signals, and a second pair of DRAC's receiving negative components of the I and Q signals, the output nodes of the first pair and second pair being connected to inputs of the matching network. This allows a class-D type of operation of the electronic circuit in a transmitter. This class-D embodiment, also allows to have each DRAC to comprise complementary NMOS and PMOS transistors. In order to provide a single-ended output, the matching network comprises a transformer circuit with a balun component.

In a further embodiment, each DRAC comprises an additional clock input, which additional clock input is a pulse width modulated version of the respective clock input. This enhances the amplitude resolution of the electronic circuit.

### Short description of drawings

The present invention will be discussed in more detail below, using a number of exemplary embodiments, with reference to the attached drawings, in which
Fig. 1 shows a block diagram of a traditional RF transmitter;
Fig. 2a shows a block diagram of an all-digital polar transmitter;
Fig. 2b shows a timing diagram of a digital-to-RF-amplitude converter;
Fig. 3 shows a block diagram of a digital I/Q transmitter;
Fig. 4a shows a schematic diagram of a first embodiment of the electronic circuit according to the present invention;
Fig. 4b shows a timing diagram of relevant signals in the circuit of Fig. 4a;
Fig. 5 shows a flow chart of the timing of the digital I/Q transmitter according to an embodiment of the present invention;
Fig. 6a shows a symbol representing an embodiment of the present invention with related signals;
Fig. 6b shows a timing diagram for the signals presented in Fig. 6a;
Fig. 7 shows a schematic diagram of a further differential class-D architecture embodiment of the present invention;
Fig. 8 shows a schematic diagram of a further embodiment of a matching network applied in an E-class architecture;
Fig. 9 shows a schematic diagram of an embodiment of a matching network applied in a D-class architecture; and
Fig. 10 shows a schematic diagram with additional optional elements of further embodiments of the present invention;

### Detailed description of exemplary embodiments

This application is claiming priority from Dutch patent application NL2003880 filed on 30 November 2009, which is incorporated herein by reference in its entirety.

The present invention relates to a method and system for (digitally) generating a radio-frequency (RF) signal to be transmitted. According to the present invention this is accomplished without any intermediate stages or without resorting to polar topology. Polar transmitter (TX) topology is a known solution that involves power amplifiers (PA). However, this technique is only proven so far for narrowband systems, and it cannot be readily used for wideband modulation schemes, such as those in WiMAX and 3GPP LTE.

The present invention embodiments can be applied in all RF transmission systems, e.g. wireless connectivity, cell phones and base stations. Cell phones or basestations can be achieved using the present invention that feature higher integration levels, better power efficiency (hence longer battery lifetime), and more sophisticated reconfigurability. They can be also advantageously used with antenna arrays, where advantages in the cost, size, power consumption are particulary sought.

In general terms, the present invention is based on the building blocks of digital power amplifiers (DPA) based on a large array of switching elements at RF rate (i.e., multi-GHz). It combines in a novel manner two DPA's and a matching network.
In an embodiment this is accomplsihed by direct coupling of I and Q digital PA states with a matching network. The two power amplifiers operate at 25% duty cycle, and the matching network is designed for 50% duty cycle in one embodiment.

Using the present invention yields a solution which shows simplicity. The solution avoids intermediate stages of adding I and Q signals, which reduce power efficiency and increase noise. Furthermore, power efficiency is improved.

Further refinements are implemented by utilizing adaptive pulse width modulation (PWM) and an adaptive duty cycle of the switching transistors, Further improvements can be made by using an adaptive matching network.

Completed circuit level simulations have shown the benefits, specifically for a 65nm CMOS process.

In the following, reference is made to the Raab's formula. The person skilled in the art will know this formula and other knowledge on digital amplifier techniques, e.g. from the following articles, which are incorporated herein by reference:
F. H. Raab, "Idealized Operation of the Class E Tuned Power Amplifier", IEEE Transactions on Circuits and Systems, Vol. CAS-24, No. 12, pp. 725-735, December 1977.
F. H. Raab, "Class-E, class-C, and class-F power amplifiers based upon a finite number of harmonics," IEEE Trans. Microwave Theory Tech., vol. 49, pp. 1462-1468, Aug. 2001.
F. H. Raab, P. Asbeck, S. C. Cripps, P. B. Kenington, Z. B. Popovic, N. Pothecary, J. F. Sevic, and N. O. Sokal, "Power amplifiers and transmitters for RF and microwave," IEEE Trans. Microw. Theory Tech., vol. 50, no. 3, pp. 814-826, Mar. 2002.
N. O. Sokal and A. D. Sokal, "Class E-A new class of high efficiency tuned single-ended switching power amplifiers," IEEE J. Solid-State Circuits, vol. SSC-10, pp. 168-176, June 1975.

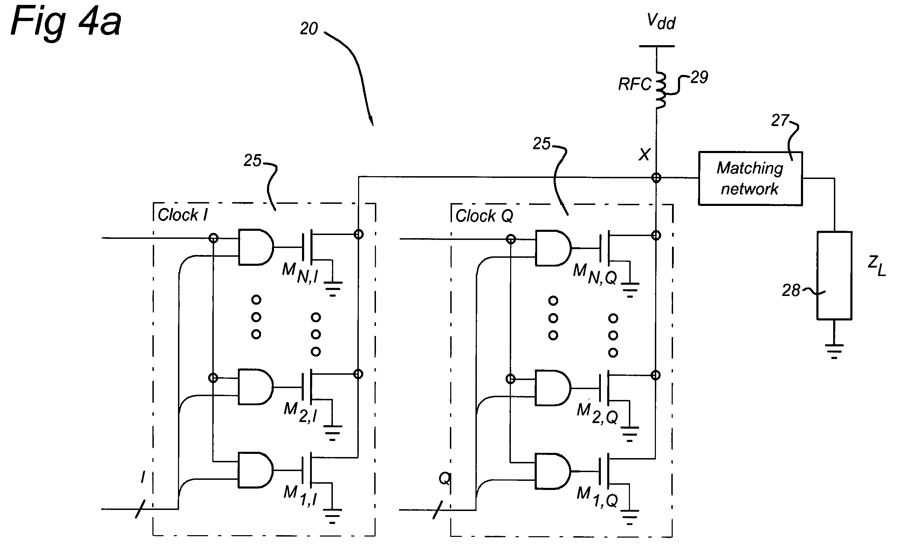

The DRAC circuit as used in the present invention embodiments is realized as a digitally-controlled RF-modulated resistor structure. A schematic view thereof is shown as part of the RF circuit diagram of Fig. 4a, inside the boundary indicated by reference numeral 25. Note that the two instances of circuit 25 are shown separately for conceptual reasons. The actual implementation does not have to be separate. In fact, it might be beneficial to make the two as part of one block or even interleave the respective switches. Each DRAC 25 has a clock input (Clock I or Clock Q) and an amplitude control word for the quadrature signal (I and Q, respectively), and comprises a series of AND-gates followed by MOS transistors M_{i,I} and M_{j,Q}. This could result in benefits of the simpler circuit, the lack of stacked devices and the lack of noisy current sources. The antenna 11 and optional PA 9 are represented in this drawing by a load 28 (Z_{L}). A supply voltage V*_{dd}* is fed to a common node X via an RF choke 29 (RFC).

In the prior art I/Q TX system described above, the final signal summation operation might be difficult to accomplish since the outputs are not currents but voltages. Hence, if it is the RF waveforms at the output of their matching networks that are to be added, then a bulky microwave-type isolator would be needed. Otherwise, the RF voltage level of the I path will affect the impedance of the Q path, and vice versa. Hence, the I/Q orthogonality will not be preserved.

On the other hand, attempting to connect together the drains of the I and Q switching transistor arrays (i.e., at the 'X' nodes of the I and Q DRAC circuits 25 as indicated in Fig. 4a) would require only a single common matching network 27, but it would also fail to preserve the orthogonality of the I/Q paths since they would depend on the each other's state. The reason for this loss of the orthogonality is the time overlap of the I/Q operations. Let us first assume that the durations of the I and Q operations are controlled by the logic high state of their respective clocks, although the actual duration is rather controlled by the clock/data overlap, i.e., their AND operation. For the conventional 50% clock duty cycle, 25% of the two clock tops coincide. During this time, the I and Q switches are simultaneously turned on, thus distorting the PA interaction of the switches with the matching network.

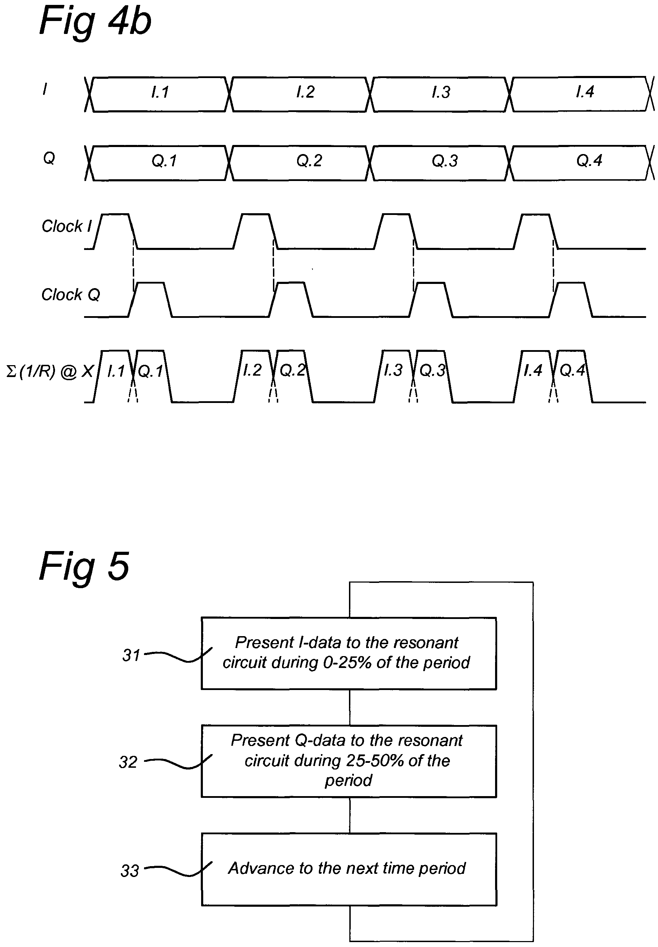

In order to eliminate this interaction, it is therefore proposed to simply avoid the overlap by reducing the clock duty cycle D to 25%, as shown in the timing diagram of Fig. 4b. Creating the *D* =25% clock from the 2x frequency differential clock is quite straightforward and merely involves dynamic selection of the proper clock edges. As apparent from the lower signal line in Fig. 4b, the matching network 27 needs to be designed to the combined duty cycle of 2 x *D =* 50%.

The solution could be thought of as a time-division duplexing (TDD), in which the linear addition of the time-shifted I and Q paths is accomplished by allocating separate time slots to enter the I/Q information into the system. The system contains the matching network 27 comprising e.g. an LC resonant circuit that serves as a memory to combine the neighboring I/Q contributions. The memory operation is a good assumption here since the LC resonant circuit has an inertia. Once the I/Q switch turn-on times are non-overlapping, the circuit operation becomes orthogonal. The orthogonality can be easily proven with the assumption of the linear time-invariant model of the switched PA, which is valid when the total switch resistance is much larger than the matching network impedance. Equivalently, the RF output power is much smaller than its saturation point. Adding an incremental switch conductance will linearly increase the RF output envelope, independent from the total instantaneous conductance level. Changing the clock phase by 90° will change the RF output carrier also by 90°. Since I and Q contributions are independent and time shifted, their vector addition will be linear.

Fig. 5 is a flowchart illustrating the operation, wherein in step 31, the I data is presented to the resonant circuit (matching network 27) during substantially 0-25% f the period. In step 32 the Q data is presented to the resonant circuit during substantially 25-50% of the period. In step 33 the system advances to the next time period.

The present invention can also be embodied as a transmitter comprising:
a modulating signal comprising an in-phase (I) component and a quadrature (Q) component; a first array of MOS transistor switches associated with said I component, said first array operative at a first duty cycle D that is substantially different than 50%; a second array of MOS transistor switches associated with said Q component, said second array operative at a second duty cycle different than 50% and substantially the same as said first duty cycle D; a matching network coupled to said first array and said second array, wherein said matching network is tuned to a substantially different duty cycle than the value of said first duty cycle D. In more general terms, the invention can also be embodied as a method for processing a modulating signal comprising an in-phase (I) component and a quadrature (Q) component, the method comprising processing the in-phase component in a first duty cycle that is substantially different than 50%; subsequently processing the quadrature component in a second duty cycle that is different than 50% and substantially the same as said first duty cycle D; advancing to a next clock cycle.

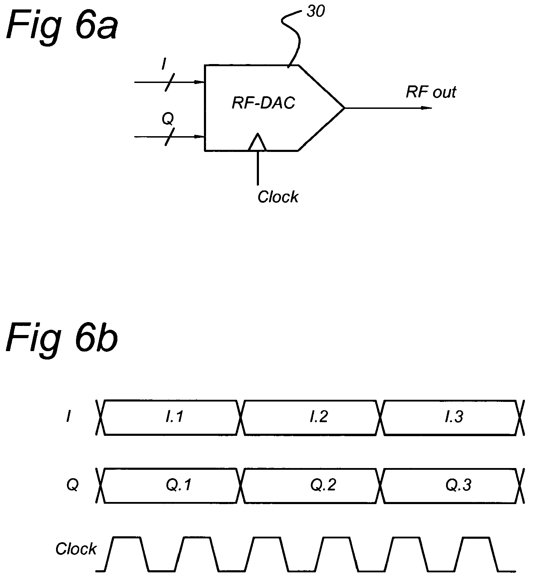

The digital I/Q RF transmitter could be also viewed as an RF-DAC 30 with clock and I/Q inputs, as shown in Fig. 6a. The clock would e.g. be provided by a low-phase-noise LO. The I/Q code words could be aligned with each other, as shown in Fig. 6b or time-shifted by *T*₀/4 or 90° to reflect their intended timing. The clock could be of twice the frequency, such that after an internal division-by-2, its falling edges could be used to create the Q clock.

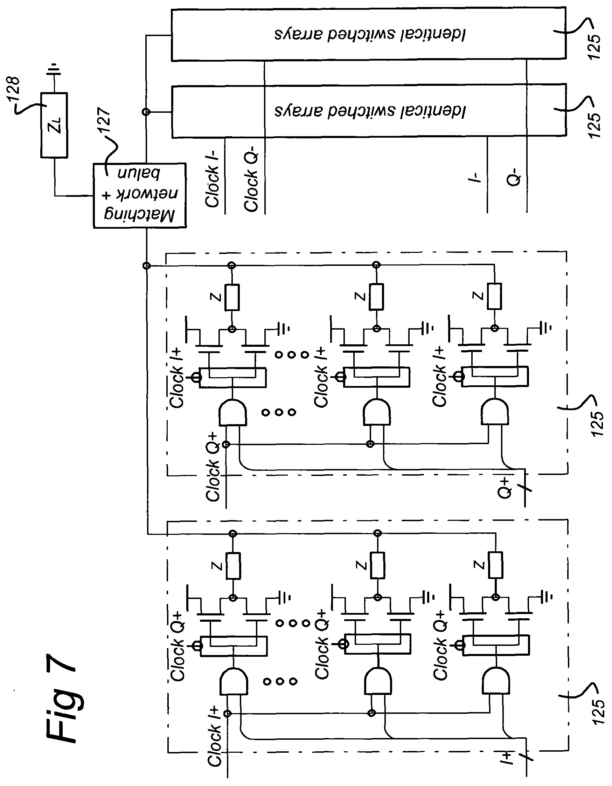

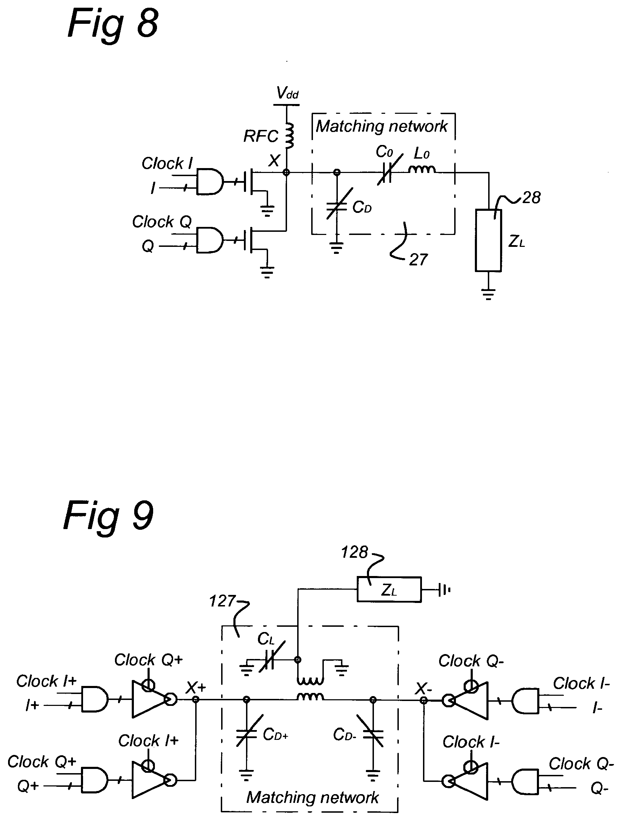

As discussed above, the proposed techniques and embodiments described above can be applied to the other classes of PA operation. Fig. 7 shows a schematic diagram of a voltage-mode class-D differential architecture. The load 128 (Z_{L}) represents again the antenna 11, optionally with a PA 9. In this embodiment four DRAC's 125 are used, one pair for the positive part and one pair for the negative part. Each DRAC 125 comprises a complementary pair of PMOS and NMOS transistors, as well as an optional impedance Z. Since the unit inverter comprising the NMOS and PMOS transistors pulls its output to either ground or supply, the voltage supply feed *V_{dd}* to the common node 'X' (as shown in the embodiment of Fig. 4) is not explicitly needed anymore. The matching network 127 can be based on a transformer, as shown in the schematic diagram of Fig. 9 and discussed below. In this case, it might provide an additional benefit of a balun (balanced-to-unbalanced) to convert the output to single-ended.

The optional Z impedance connected to each switching circuit could be a resistor, capacitor, inductor or a combination thereof. If it is bypassed (i.e., Z=0), then the RF envelope control range and resolution is controlled by the NMOS and PMOS transistor resistance, just like in the embodiment described with reference to Fig. 4. The benefits of using explicit elements of impedance Z is that it would allow to increase the resolution and dynamic range of RF envelope control in case the impedance accuracy and range are better than those of the transistor switches.

The final driving stage transistors as shown in the DRAC's 125 in the embodiments of Fig. 7 typically form an inverter. However, in order to ensure the proper TDD operation, the NMOS and PMOS transistors of the driving stage are placed in hi-Z state whenever the other associated array is used. This is achieved by pulling the gate of NMOS transistor low while pulling the gate of PMOS transistor high, using the other clock signal (Clock Q+ in the I part DRAC 125, and Clock I+ in the Q part DRAC 125). This will ensure that the common node will not be driven into conflicting states.

Fig. 8 shows a possible implementation of a matching network 27, including an output inductance Lₒ, as can be used in the class-E implementations described above. Fig. 9 shows a schematic diagram of a possible implementation of a matching network 127 in a differential (or complementary) class-D amplifier as shown in Fig. 7, including a transformer. In each of the matching networks 27, 127, there are two (resp. three) adjustable capacitors C_{L} and C_{D} (C_{D+} and C_{D-}) that need to be properly set to roughly satisfy the class-E (or class-D) operation for a given frequency.

Fig. 8 shows the class-E digital I/Q modulator from the standpoint of its matching network 27, whose design follows principles of the class-E PA. The matching network 27 components can be adjustable, either semi-statically to adjust for the new frequency channel, or dynamically to adjust the matching network impedance to the changing envelope level in order to maximize the power added efficiency (PAE). They also could be statically adjusted to account for the process variation of the various components. The adjustable capacitors C_{L} and C_{D} can be realized using digitally-switchable metal-in-metal (MiM) capacitors or MOS capacitors. Since one of the terminals of the drain capacitor (C_{D}) is grounded, it can be beneficially realized as a high-density MOS capacitor.

Fig. 9 illustrates the differential class-D digital I/Q modulator from the standpoint of its matching network 127, whose design follows principles of the class-D PA. The matching network 127 uses a transformer, which transforms the typical 50-ohm load impedance into a much lower driver impedance compatible with the low-voltage CMOS operation. The transformer's leakage inductance is also be used as part of the resonant circuit. The final driving stage of each quadrature output forms a tri-state inverter. Its output is hi-Z whenever the associated quadrature driver is enabled. For example, the I+ driver's output goes into high impedance if the Q+ driver is active. The same applies to I- and Q- drivers. This arrangement prevents driving conflicts of the two inverters whose outputs are connected (i.e., I+/Q+ as well as I-/Q-). Consequently, each inverter's output is tri-stated in three out of four quadrature time slots. It is actively driven at its allotted timeslot (one out of four time slots). In the remaining two time slots, its output is typically connected to ground (low logic state), although high logic state can also be considered as a default inactive state. Note that the driver topology of Fig. 9 forms a H-bridge structure, known as such, which produces three states: +1, 0, -1.

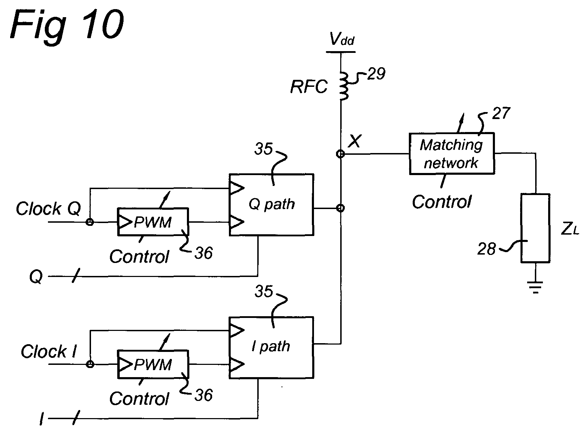

In a further embodiment of the present invention, an additional enhancement is the dynamic digital control of the matching network components. The matching network 27 has a significant effect not only on the general RFDAC operation, but also on the proper operation of the TDD I/Q combining, such as maintaining the I/Q orthogonality. This is indicated in the embodiment shown in Fig. 10 by the control arrow in the matching network 27. The matching network 27 is thus adjustable, or can be dynamically controlled.

An amplitude resolution enhancement method using incremental pulse-width modulation (PWM) was described in [22]. It was meant for a digital polar TX architecture of Fig. 2a. This technique adds an additional transistor of the same weight as the LSB transistors but the new transistor is subject to PWM. This way, an additional three bits of the RF-DAC resolution have been obtained. It is proposed to apply the same idea to the digital I/Q TX architecture. Consequently, instead of applying the incremental PWM to the single digitally-controlled RF switched resistor (DRAC 25), both such RF-switched resistor structures of Fig. 4 will undergo the incremental PWM. In the schematic diagram shown in Fig. 10, this is indicated by the PWM control module 36 in the clock path of both I and Q DRAC's 25.

In summary, a novel digital I/Q transmitter architecture is presented in the embodiments described above that avoids area, complexity, noise, distortion and linearity issues of the existing solutions by allocating separate time slots to the I and Q operations during which the respective digitally controlled RF-switched resistors, realized as arrays of MOS switches, are active. This way, the operational orthogonality of the I and Q paths is maintained and the I/Q switch arrays can be simply connected together. An example embodiment uses substantially 25% duty cycle I/Q clocks.

### List of references

[1] B. Razavi, RF Microelectronics, Upper Saddle River, NJ: Prentice Hall, 1998.
[2] T. H. Lee, The Design of CMOS Radio-Frequency Integrated Circuits,
[3] A. A. Abidi, "RF CMOS comes of age," IEEE Journal of Solid-StateCircuits, vol. 39, iss. 4, pp. 549-561, April 2004.
[4] A. Matsuzawa, "Digital-centric RF CMOS technology," IEEE Radio-Frequency Integration Technology (RFIT) Conf., pp. 122-126, Dec. 2007.
[5] P. Nagle, P. Burton Cambridge, UK: Cambridge University Press, 1998. E. Heaney, F. McGrath, "A wide-band linear amplitude modulator for polar transmitters based on the concept of interleaving delta modulation," IEEE J. Solid-State Circuits, vol. 37, no. 12, pp. 1748-1756, Dec. 2002.
[6] E. McCune and W. Sander, "EDGE transmitter alternative using nonlinear polar modulation," Proc. IEEE Int. Symp. Circuits and Systems (ISCAS), pp. 439-445, May 2003.
[7] W. B. Sander, S. V. Schell, B. L. Sander, "Polar modulator for multimode cell phones," Proc. 2003 IEEE Custom Integrated Circuits Conf., pp. 439-445, Sept. 2003.
[8] T. Sowlati, D. Rozenblit, R. Pullela, M. Damgaard, E. McCarthy, D. Koh, D. Ripley, F. Balteanu, and I. Gheorghe, "Quad-band GSM/GPRS/EDGE polar loop transmitter," IEEE J. Solid-State Circuits, vol. 39, no. 12, pp. 2179-2189, Dec. 2004.
[9] M. R. Elliott, T. Montalvo, B. P. Jeffries, F. Murden, J. Strange, A. Hill, S. Nandipaku, and J. Harrebek, "A polar modulator transmitter for GSM/EDGE," IEEE J. Solid-State Circuits, vol. 39, pp. 2190-2199, Dec. 2004.
[10] P. Reynaert, M. Steyaert, "A 1.75-GHz polar modulated RF power amplifier for GSM/EDGE," IEEE J. Solid-State Circuits, vol. 39, no.12, pp. 2598-2608, Dec. 2005.
[11] A. W. Hietala, "A quad-band 8PSK/GMSK polar transceiver," IEEE J. Solid-State Circuits, vol. 41, no. 5, pp. 1133-1141, May 2006.
[12] Y. Huang, J. H. Mikkelsen, and T. Larsen, "Investigation of polar transmitters for WCDMA handset applications," Proc. Norchip Conference, pp. 155-158, Nov. 2006.
[13] S. Akhtar, P. Litmanen, M. Ipek, J. (H.-C.) Lin , S. Pennisi, F.-J. Huang, and R. B. Staszewski, "Analog path for triple band WCDMA polar modulated transmitter in 90nm CMOS," Proc. 2007 IEEE Radio Frequency Integrated Circuits (RFIC) Symp., pp. 185-188, June 2007.
[14] R. B. Staszewski and P. T. Balsara, All-Digital Frequency Synthesizer in Deep-Submicron CMOS, New Jersey: John Wiley & Sons, Inc., Sept. 2006.
[15] R. B. Staszewski, K. Muhammad, D. Leipold, C.-M. Hung, Y.-C. Ho, J. L. Wallberg, C. Fernando, K. Maggio, R. Staszewski, T. Jung, J. Koh, S. John, I. Y. Deng, V. Sarda, O. Moreira-Tamayo, V. Mayega, R. Katz, O. Friedman, O. E. Eliezer, E. de-Obaldia, and P. T. Balsara, "All-digital TX frequency synthesizer and discrete-time receiver for Bluetooth radio in 130-nm CMOS," IEEE Journal of Solid-State Circuits, vol. 39, iss. 12, pp. 2278-2291, Dec. 2004.
[16] R. B. Staszewski, J. Wallberg, S. Rezeq, C.-M. Hung, O. Eliezer, S. Vemulapalli, C. Fernando, K. Maggio, R. Staszewski, N. Barton, M.-C. Lee, P. Cruise, M. Entezari, K. Muhammad, and D. Leipold, "All-digital PLL and transmitter for mobile phones," IEEE Journal of Solid-State Circuits, vol. 40, iss. 12, pp. 2469-2482, Dec. 2005.
[17] R. B. Staszewski, D. Leipold, O. Eliezer, M. Entezari, K. Muhammad, I. Bashir, C.-M. Hung, J. Wallberg, R. Staszewski, P. Cruise, S. Rezeq, S. Vemulapalli, K. Waheed, N. Barton, M.-C. Lee, C. Fernando, K. Maggio, T. Jung, I. Elahi, S. Larson, T. Murphy, G. Feygin, I. Deng, T. Mayhugh, Y.-C. Ho, K.-M. Low, C. Lin, J. Jaehnig, J. Kerr, J. Mehta, S. Glock, T. Almholt, S. Bhatara, "A 24mm2 quad-band single-chip GSM radio with transmitter calibration in 90nm digital CMOS," Proc. of IEEE Solid-State Circuits Conf., sec. 10.5, pp. 208-209, 607, Feb. 2008.
[18] J. Mehta, R. B. Staszewski, O. Eliezer, S. Rezeq, K. Waheed, M. Entezari, G. Feygin, S. Vemulapalli, V. Zoicas, C.-M. Hung, N. Barton, I. Bashir, K. Maggio, M. Frechette, M.-C. Lee, J. Walberg, P. Cruise, N. Yanduru, "A 0.8 mm2 all-digital SAW-less polar transmitter in 65nm EDGE SoC," Proc. of IEEE Solid-State Circuits Conf., sec. 3.2, pp. 58-59, Feb. 2010, San Francisco, CA, USA.
[19] P. Cruise, C.-M. Hung, R. B. Staszewski, O. Eliezer, S. Rezeq, D. Leipold, and K. Maggio, "A digital-to-RF-amplitude converter for GSM/GPRS/EDGE in 90-nm digital CMOS," Proc. of 2005 IEEE Radio Frequency Integrated Circuits (RFIC) Symp., sec. RMO1A-4, pp. 21-24, June 2005.
[20] A. Jerng and C. G.Sodini, "A wideband Δ∑ digital-RF modulator for high data rate transmitters," IEEE J. Solid-State Circuits, vol. 42, no. 8, pp. 1710-1722, Aug. 2007.
[21] P. Eloranta, P. Seppinen, S. Kallioinen, T. Saarela, and A. Pärssinen, "A multimode transmitter in 0.13 _m CMOS using direct-digital RF modulator," IEEE J. Solid-State Circuits, vol. 42, no. 12, pp. 2774-2784, Dec. 2007.
[22] M. Park, M. H. Perrott, and R. B. Staszewski, "A time-domain resolution improvement of an RF-DAC," IEEE Tans. Circuits Syst. II, vol. 57, no. 7, pp. 517-521, July 2010.

The present invention embodiments have been described above with reference to a number of exemplary embodiments as shown in the drawings. Modifications and alternative implementations of some parts or elements are possible, and are included in the scope of protection as defined in the appended claims.

## Claims

1. An electronic circuit, such as a transmitter, for receiving a modulating signal comprising an in-phase component (I) and a quadrature component (Q), the electronic circuit comprising a first digital-to-RF-amplitude convertor (DRAC) receiving the in-phase component and a second digital-to-RF-amplitude convertor (DRAC) receiving the quadrature component, wherein
the first digital-to-RF-amplitude convertor is operative in a first duty cycle that is different from 50% and the second digital-to-RF-amplitude convertor is operative in a second duty cycle that is different from 50% and substantially the same in value as said first duty cycle.

2. Electronic circuit according to claim 1, wherein the first duty cycle is 25% and the second duty cycle is 25%.

3. Electronic circuit according to claim 1 or 2, wherein the first DRAC receives an I-clock signal and the second DRAC receives a Q-clock signal, the duty cycle of the I-clock signal being equal to the first duty cycle and the duty cycle of the Q-clock signal being equal to the second duty cycle, the first duty cycle and second duty cycle being subsequent to each other in time.

4. Electronic circuit according to any one of claims 1-3, wherein the in-phase component and the quadrature component comprise a respective amplitude control word,
each of the first and second DRAC's comprising a controllable switch array having an array of AND gates, each AND gate receiving the respective clock signal and one of the bits of the respective ACW, the output of each AND gates being connected to an associated one of a plurality of MOS transistor switches, the outputs of each of the plurality of MOS transistors being connected to a summation node.

5. Electronic circuit according to claim 4, wherein the switch arrays of the first and second DRAC's are implemented in the electronic circuit with an interleaved lay-out.

6. Electronic circuit according to claim 4 or 5, wherein each of the first and second DRAC comprises an output impedance connected in series between the output of each MOS transistor and the summation node.

7. Electronic circuit according to any one of claims 1-6, wherein the first DRAC and the second DRAC form one circuit.

8. Electronic circuit according to any one of claims 1-7, the electronic circuit further comprising a matching network for driving an analog RF part, the matching network being connected to a summation node of the first and second DAC, and comprising an LC resonant circuit which combines subsequent I and Q contributions in a single clock cycle.

9. Electronic circuit according to claim 8, wherein the matching network operates with a third duty cycle which is equal to the sum of the first duty cycle and the second duty cycle.

10. Electronic circuit according to claim 8 or 9, wherein the matching network is adjustable.

11. Electronic circuit according to claim 8 or 9, wherein the matching network is dynamically controlled.

12. Electronic circuit according to any one of claims 1-11, wherein the electronic circuit comprises a first pair of DRAC's receiving positive components of the I and Q signals, and a second pair of DRAC's receiving negative components of the I and Q signals, the output nodes of the first pair and second pair being connected to inputs of the matching network.

13. Electronic circuit according to claim 12, wherein each DRAC comprises complementary NMOS and PMOS transistors.

14. Electronic circuit according to claim 12 or 13, wherein the matching network comprises a transformer circuit with a balun component.

15. Electronic circuit according to any one of claims 1-14, wherein each DRAC comprises an additional clock input, which additional clock input is a pulse width modulated version of the respective clock input.

## Patentansprüche

1. Elektronische Schaltung, wie etwa ein Sender, zum Empfangen eines Modulationssignals mit einer phasengleichen Komponente (I) und einer Quadratur-Komponente (Q), wobei die elektronische Schaltung einen ersten Digital-HochfrequenzAmplitudenkonverter (DRAC), der die phasengleiche Komponente aufnimmt, und einen zweiten Digital-HochfrequenzAmplitudenkonverter (DRAC) aufweist, der die Quadratur-Komponente empfängt, wobei
der erste Digital-Hochfrequenz-Amplitudenkonverter in einem ersten Arbeitszyklus im Betrieb ist, der von 50% verschieden ist, und der zweite Digital-Hochfrequenz-Amplitudenkonverter in einem zweiten Arbeitszyklus im Betrieb ist, der von 50% verschieden ist und im Wesentlichen denselben Wert wie der erste Arbeitszyklus hat.

2. Elektronische Schaltung nach Anspruch 1, wobei der erste Arbeitszyklus 25% ist und der zweite Arbeitszyklus 25% ist.

3. Elektronische Schaltung nach Anspruch 1 oder 2, wobei der erste DRAC ein I-Taktsignal und der zweite DRAC ein Q-Taktsignal empfängt, wobei das Tastverhältnis des I-Taktsignals gleich dem ersten Arbeitszyklus und das Tastverhältnis des Q-Taktsignals gleich dem zweiten Arbeitszyklus ist, wobei der erste Arbeitszyklus und der zweite Arbeitszyklus zeitlich nacheinander liegen.

4. Elektronische Schaltung nach einem der Ansprüche 1 - 3, wobei die phasengleiche Komponente und die Quadratur-Komponente jeweils ein Amplituden-Steuerwort umfassen,
jeder von dem ersten und zweiten DRACs ein steuerbares Schaltfeld mit einem Feld von UND-Gattern aufweist, wobei jedes UND-Gatter ein jeweiliges Taktsignal und eines der Bits des jeweiligen Amplituden-Steuerworts empfängt, der Ausgang jedes UND-Gatters mit einem zugeordneten aus einer Vielzahl von MOS-Transistorschaltern verbunden ist, die Ausgänge von allen aus der Mehrzahl von MOS-Transistoren mit einem Summierungsknoten verbunden sind.

5. Elektronische Schaltung nach Anspruch 4, wobei die Schaltfelder der ersten und zweiten DRACs in der elektronischen Schaltung mit einer verschachtelten Anordnung implementiert sind.

6. Elektronische Schaltung nach Anspruch 4 oder 5, wobei jeder von dem ersten und dem zweiten DRAC eine Ausgangsimpedanz hat, die in Reihe zwischen dem Ausgang jedes MOS-Transistors und dem Summierungsknoten geschaltet ist.

7. Elektronische Schaltung nach einem der Ansprüche 1 - 6, wobei der erste DRAC und der zweite DRAC eine Schaltung bilden.

8. Elektronische Schaltung nach einem der Ansprüche 1 - 7, wobei die elektronische Schaltung weiter ein Anpassungsnetzwerk aufweist, um einen analogen Hochfrequenz-Teil zu treiben, wobei das Anpassungsnetzwerk mit einem Summierungsknoten des ersten und des zweiten DRAC verbunden ist und einen LC-Schwingkreis aufweist, der aufeinanderfolgende I- und Q-Beiträge in einem einzelnen Taktzyklus kombiniert.

9. Elektronische Schaltung nach Anspruch 8, wobei das Anpassungsnetzwerk mit einem dritten Arbeitszyklus arbeitet, der gleich der Summe des ersten Arbeitszyklus und des zweiten Arbeitszyklus ist.

10. Elektronische Schaltung nach Anspruch 8 oder 9, wobei das Anpassungsnetzwerk einstellbar ist.

11. Elektronische Schaltung nach Anspruch 8 oder 9, wobei das Anpassungsnetzwerk dynamisch gesteuert wird.

12. Elektronische Schaltung nach einem der Ansprüche 1 - 11, wobei die elektronische Schaltung ein erstes Paar von DRACs, die positive Komponenten der I- und Q-Signale empfangen, und ein zweites Paar von DRACs aufweist, die negative Komponenten der I- und Q-Signale empfängt, wobei die Ausgangsknoten des ersten Paares und des zweiten Paars mit den Eingängen des Anpassungsnetzwerks verbunden sind.

13. Elektronische Schaltung nach Anspruch 12, wobei jeder DRAC komplementäre NMOS- und PMOS-Transistoren aufweist.

14. Elektronische Schaltung nach Anspruch 12 und 13, wobei das Anpassungsnetzwerk einen Transformator mit einem Symmetrierglied aufweist.

15. Elektronische Schaltung nach einem der Ansprüche 1 - 14, wobei jeder DRAC einen zusätzlichen Takteingang aufweist, wobei der zusätzliche Takteingang eine pulsbreitenmodulierte Version des jeweiligen Takteingangs ist.

## Revendications

1. Circuit électronique, tel qu'un transmetteur, destiné à recevoir un signal de modulation comprenant une composante en phase (I) et une composante en quadrature (Q), le circuit électronique comprenant un premier convertisseur d'amplitude-RF numérique (DRAC) recevant la composante en phase et un second convertisseur d'amplitude-RF numérique (DRAC) recevant la composante en quadrature, dans lequel
le premier convertisseur d'amplitude-RF numérique est opérant dans un premier rapport cyclique qui est différent de 50% et le second convertisseur d'amplitude-RF numérique est opérant dans un deuxième rapport cyclique qui est différent de 50% et qui a sensiblement la même valeur que ledit premier rapport cyclique.

2. Circuit électronique selon la revendication 1, dans lequel le premier rapport cyclique est de 25% et le deuxième rapport cyclique est de 25%.

3. Circuit électronique selon la revendication 1 ou 2, dans lequel le premier DRAC reçoit un signal d'horloge I et le second DRAC reçoit un signal d'horloge Q, le rapport cyclique du signal d'horloge I étant égal au premier rapport cyclique et le rapport cyclique du signal d'horloge Q étant égal au deuxième rapport cyclique, le premier rapport cyclique et le deuxième rapport cyclique étant postérieur l'un à l'autre dans le temps.

4. Circuit électronique selon l'une quelconque des revendications 1 à 3, dans lequel la composante en phase et la composante en quadrature comprennent un mot de commande d'amplitude respectif,
chacun des premier et second DRAC comprenant une matrice de commutateurs commandable pourvu d'un réseau de portes ET, chaque porte ET recevant le signal d'horloge respectif et l'un des bits du mot de commande d'amplitude (ACW) respectif, la sortie de chaque porte ET étant connectée à l'une associée d'une pluralité de commutateurs à transistor MOS, les sorties de chacun de la pluralité de transistors MOS étant connectées à un noeud de sommation.

5. Circuit électronique selon la revendication 4, dans lequel les matrices de commutateur des premier et second DRAC sont implémentées dans le circuit électronique selon un agencement entrelacé.

6. Circuit électronique selon la revendication 4 ou 5, dans lequel chacun des premier et second DRAC a une impédance de sortie connectée en série entre la sortie de chaque transistor MOS et le noeud de sommation.

7. Circuit électronique selon l'une quelconque des revendications 1 à 6, dans lequel le premier DRAC et le second DRAC forme un circuit.

8. Circuit électronique selon l'une quelconque des revendications 1 à 7, le circuit électronique comprenant en outre un réseau d'adaptation qui sert à entraîner un élément RF analogique, le réseau d'adaptation étant connecté à un noeud de sommation des premier et second DAC, et comprenant une circuit résonant LC qui combine les contributions I et Q suivantes en un seul cycle d'horloge.

9. Circuit électronique selon la revendication 8, dans lequel le réseau d'adaptation fonctionne avec un troisième rapport cyclique qui est égal à la somme des premier et deuxième rapports cycliques,

10. Circuit électronique selon la revendication 8 ou 9, dans lequel le réseau d'adaptation est ajustable.

11. Circuit électronique selon la revendication 8 ou 9, dans lequel le réseau d'adaptation est commandé dynamiquement.

12. Circuit électronique selon l'une quelconque des revendications 1 à 11, dans lequel le circuit électronique comprend une première paire de DRAC recevant des composantes positives des signaux I et Q, et une seconde paire de DRAC recevant des composantes négatives des signaux I et Q, les noeuds de sortie des première et seconde paires étant connectés aux entrées du réseau d'adaptation.

13. Circuit électronique selon la revendication 12, dans lequel chaque DRAC comprend des transistors NMOS et PMOS complémentaires.

14. Circuit électronique selon la revendication 12 ou 13, dans lequel le réseau d'adaptation comprend un circuit de transformateur pourvu d'un composant symétriseur.

15. Circuit électronique selon l'une quelconque des revendications 1 à 14, dans lequel chaque DRAC comprend une entrée d'horloge supplémentaire, laquelle entrée d'horloge supplémentaire est une version modulée en largeur d'impulsion de l'entrée d'horloge respective.
